# EUROPEAN PATENT APPLICATION

(11) **EP 4 626 210 A1**
(43) Date of publication of application: **01.10.2025**
(21) Application number: 24859686.8
(22) Date of filing: 26.08.2024
(51) Int. Cl.: H10N 30/853, H03H 9/17, H10N 30/06, H10N 30/20, H10N 30/30, H10N 30/87

(54) **THIN FILM PIEZOELECTRIC DEVICE**

(30) Priority: 25.08.2023 JP 2023137419
(71) Applicant: I-PEX Piezo Solutions Inc., Ube-shi, Yamaguchi 755-0152 (JP)
(72) Inventor: KONISHI, Akio, Ube-shi, Yamaguchi 755-0152 (JP); KANAMORI, Hiroaki, Ube-shi, Yamaguchi 755-0152 (JP); IIZUKA, Takeshi, Ube-shi, Yamaguchi 755-0152 (JP); TAKEISHI, Yuma, Ube-shi, Yamaguchi 755-0152 (JP)
(74) Representative: Berggren Oy
(86) International application number: PCT/JP2024/030191
(87) International publication number: WO 2025/047653

(57) **Abstract**

Provided is a thin-film piezoelectric device that has superior piezoelectric properties and exhibits a large displacement. The thin-film piezoelectric device includes a substrate; and a moving part supported by the substrate. The moving part includes at least: a buffer film including zirconium oxide (ZrO₂) provided on the substrate; a first electrode layer provided on the buffer film; a piezoelectric film provided on the first electrode layer; and a second electrode layer provided on the piezoelectric film. The piezoelectric film is a (001)- or (100)-oriented film including a single crystal of lead zirconate titanate (Pb(Zr,Ti)O₃ (PZT)), barium titanate (BaTiO₃ (BT)), or potassium sodium niobate ((K,Na)NbO₃ (KNN)). The piezoelectric film in the moving part expands and contracts in an in-plane direction in relation to a d₃₁ mode based on a piezoelectric effect, thereby causing the moving part to be displaced, so that an angle θ between a <100> direction of the piezoelectric film and an in-plane direction which maximizes a displacement of the moving part is within ±11.5°.

## Description

### TECHNICAL FIELD

The present invention relates to a thin-film piezoelectric device.

### BACKGROUND ART

In recent years, with the advancement of highly information-based society, there has been a growing focus on thin-film piezoelectric devices. In particular, the fifthgeneration mobile communication system (5G), which was launched in 2020, has been a strong driving force for the development of thin-film piezoelectric devices. Specifically, 5G, which has features such as high speed and large capacity, multiple simultaneous connections, and ultra-low latency, can realize an IoT society in which various things are connected to the Internet. In such an IoT society, various sensors and actuators will be frequently used for information input/output devices, and thus small high-performance thin-film piezoelectric devices will be demanded for use in such information input/output devices.

Thin-film piezoelectric devices include piezoelectric elements integrated on a semiconductor substrate using MEMS (Micro Electro Mechanical Systems) technology, which enables the miniaturization and high integration of the elements. Piezoelectric elements utilize a piezoelectric effect of a piezoelectric material, namely a phenomenon of direct conversion between electrical and mechanical signals. The piezoelectric effect includes a positive piezoelectric effect, which converts mechanical signals to electrical signals, and an inverse piezoelectric effect, which converts electrical signals to mechanical signals. Based on the positive piezoelectric effect, a thin-film piezoelectric device can serve as a sensor. Based on the inverse piezoelectric effect, a thin-film piezoelectric device can serve as an actuator.

Various piezoelectric materials are known, of which perovskite compounds such as lead zirconate titanate (Pb(Zr,Ti)O₃ (PZT)) are widely used. Perovskite compounds have a composition represented by the formula ABO₃, in which the A- and B-site cations are displaced to cause dielectric polarization. Upon application of mechanical pressure, the magnitude and direction of the dielectric polarization change to produce the piezoelectric effect.

Patent Document 1 discloses a thin-film piezoelectric device including: a Si substrate; an epitaxial metal thin-film on the Si substrate; and a PZT thin-film on the metal thin-film, in which the PZT thin-film has an atomic ratio Ti/(Ti + Zr) of 0.65 to 0.90 (see claim 1 of Patent Document 1). Patent Document 1 also states that the thin-film piezoelectric device can be used to form thin-film oscillators for mobile communication devices, thin-film VCOs, thin-film filters, liquid ejectors, or other devices and that it can provide a high-performance piezoelectric device, such as FBAR with an order of magnitude broader bandwidth (see paragraphs [0001] and [0068] of Patent Document 1).

Patent Document 2 discloses a method for manufacturing a single-crystal wafer, including the steps of: preparing polygonal substrates of a single-crystal material; stacking and bonding the polygonal substrates to form a polygonal columnar multilayer block; processing the polygonal columnar multilayer block into a cylindrical shape to form a first orientation flat; and forming a second orientation flat on the arc edge of the multilayer block (see claim 1 of Patent Document 2). Patent Document 2 also states that the single-crystal wafer may be a piezoelectric substrate (see paragraph [0018] of Patent Document 2).

Non-patent Document 1 discloses synthesizing a lead zirconate titanate (PZT) thin film on a silicon substrate using sol-gel method and measuring the transverse piezoelectric constant (d₃₁) of the synthesized PZT thin film using wafer bending method, where the piezoelectric constant (d₃₁) is 25 to 60 pC/N (see Abstract on page 133 and 6. Preliminary Results and Fig. 4 on page 136 of Non-Patent Document 1).
Patent Document 1: Japanese Unexamined Patent Application, Publication No. 2000-332569
Patent Document 2: Japanese Unexamined Patent Application, Publication No. 2013-115534
Non-Patent Document 1: J.F. Shepard Jr. et al., The wafer flexure technique for the determination of the transverse piezoelectric coefficient (d31) of PZT thin films, Sensors and Actuators A71 (1998) 133-138

### DISCLOSURE OF THE INVENTION

### Problems to be Solved by the Invention

Although some thin-film piezoelectric devices have been proposed as described above, such conventional thin-film piezoelectric devices have room for improvement. Specifically, piezoelectric devices is required to exhibit a large displacement upon voltage application. In this regard, general thin-film piezoelectric devices use a polycrystalline piezoelectric material which does not have crystal growth along the crystal orientation of the substrate. Therefore, in such a piezoelectric material, the magnitude (amount) of the displacement does not change depending on the crystal orientation of the material, which means that there is a limit to increasing the magnitude of the displacement. Since the magnitude of the displacement does not change depending on the crystal orientation, such a general thin-film piezoelectric devices have been fabricated such that they are arranged parallel or perpendicular to the orientation flat or notch of a substrate wafer.

Incidentally, Patent Document 2 discloses a piezoelectric substrate derived from a single-crystal wafer, but the substantial material disclosed therein is quartz (see paragraph [0021] of Patent Document 2). Although quartz has high long-term stability, it is inferior to perovskite compounds in terms of charge output. In addition, Patent Document 2 does not disclose the integration of piezoelectric materials on a semiconductor substrate and is not intended for thin-film piezoelectric devices.

The present inventors have conducted diligent research to provide a solution to such conventional problems. As a result, the present inventors have found that, in a thin-film piezoelectric device, a single-crystalline piezoelectric film exhibits piezoelectric properties highly dependent on the plane orientation, and that a strict control of the plane orientation realizes improved piezoelectric properties. Specifically, the present inventors have found that, in such a device, the magnitude of displacement can be increased by controlling the angle θ between the <100> direction of the piezoelectric film and the in-plane direction which maximizes the displacement of the moving part.

It is an object of the present invention, which has been completed based on such findings, to provide a thin-film piezoelectric device that has superior piezoelectric properties and exhibits a large displacement.

### Means for Solving the Problems

The present invention encompasses aspects (1) to (12) below. As used herein, a phrase consisting of numerical values and "to" therebetween means the range between the numerical values (inclusive). In other words, the phrase "X to Y" is interchangeable with "X or more and Y or less".
(1) A thin-film piezoelectric device including: a substrate; and a moving part supported by the substrate,
   the moving part including at least: a buffer film including zirconium oxide (ZrO₂) provided on the substrate; a first electrode layer provided on the buffer film; a piezoelectric film provided on the first electrode layer; and a second electrode layer provided on the piezoelectric film,
   the piezoelectric film being a (001)- or (100)-oriented film including a single crystal of lead zirconate titanate (Pb(Zr,Ti)O₃ (PZT)), barium titanate (BaTiO₃ (BT)), or potassium sodium niobate ((K,Na)NbO₃ (KNN)),
   wherein the piezoelectric film in the moving part expands and contracts in an in-plane direction in relation to a d₃₁ mode based on a piezoelectric effect, thereby causing the moving part to be displaced, and
   wherein an angle θ between a <100> direction of the piezoelectric film and an in-plane direction which maximizes a displacement of the moving part is within ±11.5°.
(2) The thin-film piezoelectric device according to aspect (1), wherein, in top view, the moving part has an external shape with two sides parallel to each other, and wherein the in-plane direction which maximizes a displacement of the moving part is consistent with a direction perpendicular to the two sides.
(3) The thin-film piezoelectric device according to aspect (2), wherein the external shape of the moving part is rectangular, substantially rectangular, or trapezoidal.
(4) The thin-film piezoelectric device according to any one of aspects (1) to (3), wherein one or both of the first and second electrode layers include at least one selected from the group consisting of platinum (Pt), molybdenum (Mo), ruthenium (Ru), aluminum (Al), and copper (Cu).
(5) The thin-film piezoelectric device according to any one of aspects (1) to (4), further including a first metal oxide film including strontium ruthenate (SrRuO₃ (SRO)) between the first electrode layer and the piezoelectric film.
(6) The thin-film piezoelectric device according to any one of aspects (1) to (5), further including a second metal oxide film including strontium ruthenate (SrRuO₃ (SRO)) between the piezoelectric film and the second electrode layer.
(7) The thin-film piezoelectric device according to any one of aspects (1) to (6), wherein the substrate is a Si substrate or an SOI substrate.
(8) The thin-film piezoelectric device according to any one of aspects (1) to (7), wherein the piezoelectric film includes a single crystal of lead zirconate titanate (Pb(Zr,Ti)O₃ (PZT)).
(9) The thin-film piezoelectric device according to any one of aspects (1) to (8), wherein the buffer film and the first electrode layer each include a single crystal.
(10) The thin-film piezoelectric device according to aspect (9), wherein the buffer film, the first electrode layer, and the piezoelectric film have the same crystal orientation.
(11) The thin-film piezoelectric device according to any one of aspects (1) to (10), wherein the thin-film piezoelectric device has a double-supported beam structure or a single-supported beam structure, and wherein the moving part forms a beam in the double- or single-supported beam structure.
(12) The thin-film piezoelectric device according to any one of aspects (1) to (11), wherein the thin-film piezoelectric device is for use as a sensor or an actuator.

### Effects of the Invention

The present invention provides a thin-film piezoelectric device that has superior piezoelectric properties and exhibits a large displacement.

### BRIEF DESCRIPTION OF THE DRAWINGS

FIG. 1 is a schematic cross-sectional view of an exemplary thin-film piezoelectric device;
FIG. 2 is a schematic cross-sectional view of another exemplary thin-film piezoelectric device;
FIG. 3 is a top view of a thin-film piezoelectric device;
FIG. 4 is a top view of a thin-film piezoelectric device;
FIG. 5 is a diagram showing a relationship between angle α and the magnitude of displacement (cavity width 70 µm);
FIG. 6 is a diagram showing a relationship between angle α and the magnitude of displacement (cavity width 200 µm);
FIG. 7 is a diagram showing a relationship between angle α and resonance frequency Fa (cavity width 70 µm);
FIG. 8 is a diagram showing a relationship between angle α and resonance frequency Fa (cavity width 200 µm);
FIG. 9 is a diagram showing a relationship between angle α and the magnitude of displacement/resonance frequency Fa (cavity width 70 µm);
FIG. 10 is a diagram showing a relationship between angle α and the magnitude of displacement/resonance frequency Fa (cavity width 200 µm);
FIG. 11A is a graph showing an X-ray diffraction pattern (Φ scan) of a piezoelectric (PZT) film; and
FIG. 11B a graph showing an X-ray diffraction pattern (Φ scan) of a piezoelectric (PZT) film.

### PREFERRED MODE FOR CARRYING OUT THE INVENTION

Specific embodiments of the present invention (hereinafter referred to as "embodiments") will be described. It will be understood that the embodiments are not intended to limit the present invention and may be altered or modified in various ways without departing from the gist of the present invention.

### 1. Thin-Film Piezoelectric Device

An embodiment is directed to a thin-film piezoelectric device (hereinafter also simply referred to as the "device") including a substrate and a moving part supported by (on) the substrate. The moving part includes at least: a buffer film including zirconium oxide (ZrO₂) provided on the substrate; a first electrode layer provided on the buffer film; a piezoelectric film provided on the first electrode layer; and a second electrode layer provided on the piezoelectric film. The piezoelectric film is a (001)- or (100)-oriented single crystal film of lead zirconate titanate (Pb(Zr,Ti)O₃ (PZT)), barium titanate (BaTiO₃ (BT)), or potassium sodium niobate ((K,Na)NbO₃ (KNN)). The piezoelectric film in the moving part expands and contracts in an in-plane direction in relation to a d₃₁ mode based on a piezoelectric effect, thereby causing the moving part to be displaced. An angle θ between a <100> direction of the piezoelectric film and an in-plane direction which maximizes a displacement of the moving part is within ±11.5°.

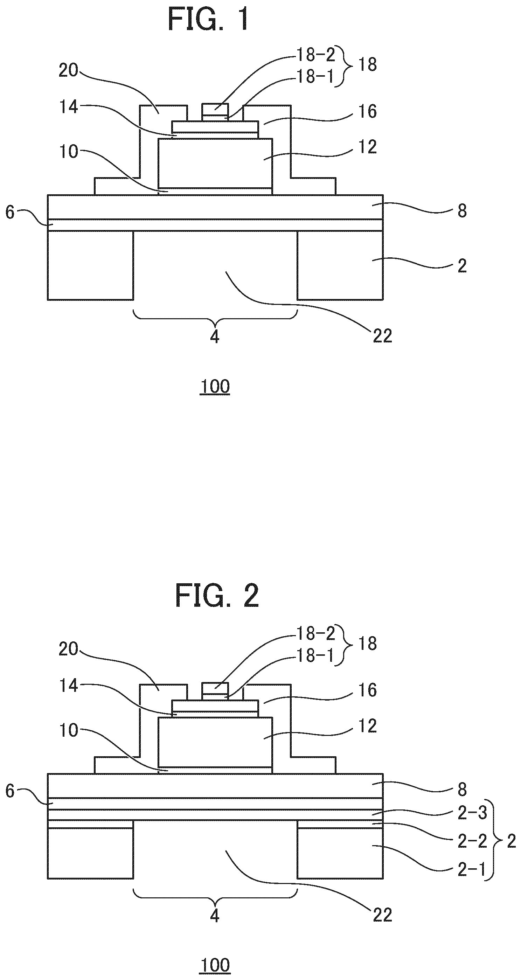

The thin-film piezoelectric device according to an embodiment will be described with reference to FIGS. 1 and 2. FIG. 1 is a schematic cross-sectional view of an example of the device including a Si substrate. The thin-film piezoelectric device (100) includes a Si substrate (2) and a moving part (4) supported by the Si substrate (2). The Si substrate (2) has at least a portion removed to form a hollow portion (22). The moving part (4) is provided above the hollow portion (22) and includes a buffer film (6) provided on the Si substrate (2); a first electrode layer (8) provided on the buffer film (6); a first metal oxide film (10) provided on the first electrode layer (8); a piezoelectric film (12) provided on the first metal oxide film (10); a second metal oxide film (14) provided on the piezoelectric film (12); a second electrode layer (16) provided on the second metal oxide film (14); and an extraction electrode (18) provided in electrical contact with the second electrode layer (16). The first electrode layer (8) and the second electrode layer (16) each include a Pt film. The first metal oxide film (10) and the second metal oxide film (14) each include an SRO film. The piezoelectric film (12) includes a PZT film. The extraction electrode (18) includes a stack of a Ti layer (18-1) and a Au layer (18-2). A protective film (20) is further provided to cover the first electrode layer (8), the first metal oxide film (10), the piezoelectric film (12), the second metal oxide film (14), and the second electrode layer (16).

FIG. 2 is a schematic cross-sectional view of another example of the device including an SOI substrate. In this case, an SOI substrate (2) is used instead of the Si substrate. The SOI substrate (2) includes a Si substrate portion (2-1), a surface Si layer (2-3), and an insulating film (2-2), such as a SiO₂ film, provided between them. The thin-film piezoelectric device (100) includes the SOI substrate (2) and a moving part (4) supported by the SOI substrate (2) and has the same features as those of the Si substrate device except for those mentioned above. The SOI substrate has at least a portion removed to form a hollow portion (22). The moving part (4) is provided above the hollow portion (22) and includes a buffer film (6), a first electrode layer (8), a first metal oxide film (10), a piezoelectric film (12), a second metal oxide film (14), a second electrode layer (16), an extraction electrode (18), and a protective film (20).

### Substrate

The substrate functions as the base of the thin-film piezoelectric device and also supports the moving part. The substrate may be made of any suitable material. The substrate may be a known substrate used for thin-film piezoelectric devices. For example, such a substrate may be a silicon (Si) substrate, a silicon-on-insulator (SOI) substrate, a substrate made of a semiconductor crystal other than Si, a substrate made of a single crystal of any of various oxides such as sapphire and garnet, or a glass substrate with a surface polysilicon film. The SOI substrate has a structure including a Si substrate portion, a surface Si layer, and an insulating film (e.g., a SiO₂ film) provided between them. The substrate may be of any size, such as a 4-inch substrate, a 6-inch substrate, or an 8-inch substrate.

The substrate is preferably a Si substrate or an SOI substrate and more preferably a Si (100) substrate or an SOI (100) substrate. As used herein, the term "(100) substrate" refers to a substrate having a (100) crystal lattice plane facing to the direction perpendicular to the main face of the substrate. On a Si or SOI (100) substrate, a single-crystalline buffer film, a single-crystalline first electrode layer, and a single-crystalline piezoelectric film can be epitaxially grown such that their lattices match well. However, after a single-crystalline piezoelectric film is formed on a substrate, the substrate may be separated or removed, and another substrate may be joined to the piezoelectric film. In the thin-film piezoelectric device according to an embodiment, therefore, the substrate should not be limited to a Si or SOI (100) substrate. The substrate may also be any other substrate such as a (110) substrate or a (111) substrate.

The substrate may or may not constitute the moving part. In the device of FIG. 1 having a Si substrate, the buffer film (6) forms the bottom layer of the moving part (4). In other words, the Si substrate (2) does not constitute the moving part (4). In the device of FIG. 2 having an SOI substrate, however, the surface Si layer (2-3) of the SOI substrate (2) forms the bottom layer of the moving part (4). In other words, the SOI substrate (2) constitutes part of the moving part (4).

### Buffer Film

The device according to an embodiment has a buffer film including zirconium oxide (ZrO₂). The buffer film is provided on the substrate. The buffer film also forms the moving part. The buffer film including ZrO₂ can promote monocrystallization of the piezoelectric film being formed thereon. Specifically, ZrO₂ has a monoclinic, tetragonal, or cubic crystal structure. During crystal growth on the substrate, the ZrO₂ buffer film with such a crystal structure can form a nanopyramid surface structure. During the formation of the first electrode layer and the piezoelectric film on the ZrO₂ buffer film with such a nanopyramid structure, the nanopyramid structure can deform itself to compensate for misalignment between the crystal lattices of the substrate and the films. This can result in the formation of single crystal films with low residual stress.

The buffer film may include only ZrO₂ or may include ZrO₂ and a rare earth element or an alkaline earth element. The ZrO₂ may also contain oxygen defects. To have improved properties, the buffer film may further contain a transition metal element, such as aluminum (Al), scandium (Sc), manganese (Mn), iron (Fe), cobalt (Co), and/or nickel (Ni).

The buffer film preferably has a thickness of 10 nm or more and 1,500 nm or less, more preferably 20 nm or more and 1,200 nm or less, even more preferably 30 nm or more and 1,000 nm or less. The buffer film is preferably an epitaxial film, more preferably a (100)-oriented epitaxial film, grown on the substrate.

### First Electrode Layer

The first and second electrode layers form a pair of electrodes between which the piezoelectric film is sandwiched. Through the electrode layers, the potential difference caused by the surface charge of the piezoelectric film can be detected when the surface charge is generated by the positive piezoelectric effect. Alternatively, a potential difference may be applied to the piezoelectric film across the electrode layers to cause inverse piezoelectric effect-induced strain. The first electrode layer may be made of any electrically-conductive material. For example, the first electrode layer may include at least one selected from the group consisting of platinum (Pt), molybdenum (Mo), ruthenium (Ru), aluminum (Al), and copper (Cu).

The first electrode layer preferably has a thickness of 10 nm or more and 500 nm or less, more preferably 30 nm or more and 300 nm or less, even more preferably 50 nm or more and 200 nm or less. The first electrode layer is preferably an epitaxial film, more preferably a (100)-oriented epitaxial film, grown on the buffer film.

### First Metal Oxide Film

The thin-film piezoelectric device according to an embodiment may have a first metal oxide film between the first electrode layer and the piezoelectric film. The first metal oxide film preferably includes strontium ruthenate (SrRuO₃ (SRO)). SRO is electrically conductive. Therefore, the SRO film (first metal oxide film) may be used as part of the electrode layer (first electrode layer). In addition, SRO has a perovskite crystal structure, which is same as PZT, BT or KNN forming the piezoelectric film, and has a lattice constant close to that of PZT, BT, or KNN. Therefore, when the SRO film is provided between the first electrode layer and the piezoelectric film, the piezoelectric film grown on the SRO film can have more improved crystallinity. Piezoelectric films with a thickness as small as submicron size are particularly prone to crystal defects. Even with a submicron thickness, however, the piezoelectric film grown on the first metal oxide film will have less crystal defects. Nevertheless, the first metal oxide film is not an essential component. Without the first metal oxide film, the piezoelectric film will have less crystal defects when formed with a sufficiently large thickness.

The first metal oxide film (SRO film) preferably has a thickness of 1 nm or more and 100 nm or less, more preferably 3 nm or more and 80 nm or less, even more preferably 5 nm or more and 60 nm or less. The first metal oxide film is preferably an epitaxial film, more preferably a (100)-oriented epitaxial film, grown on the first electrode layer.

### Piezoelectric Film

The piezoelectric film is a component that is mainly responsible for the piezoelectric effect and achieves conversion between electrical energy and mechanical energy. Specifically, when a pressure (force) is applied to the piezoelectric film, a positive piezoelectric effect appears to generate electric charges on the top and bottom surfaces of the piezoelectric film, which will cause a potential difference (voltage). This allows the piezoelectric film to serve as a sensor. Alternatively, when a potential difference (voltage) is applied across the top and bottom surfaces of the piezoelectric film, an inverse piezoelectric effect appears to displace the piezoelectric film. This allows the piezoelectric film to serve as an actuator.

The piezoelectric film according to an embodiment is characterized by a single crystal film. Specifically, the piezoelectric film has a continuous crystal structure extending along its cross-section and top surface and has a Cube-on-Cube structure, that is, a crystal structure somewhat like dice stacked up so they will not roll. Thus, the piezoelectric film has a microstructure different from that of conventional piezoelectric films. Specifically, conventional piezoelectric films are polycrystalline films including multiple crystal grains oriented randomly in the thickness and in-plane directions or are films having random orientations in the in-plane direction although having continuous crystals in the thickness direction. Epitaxial films oriented in the thickness and in-plane directions have also been proposed, but such films are polycrystalline with no continuous crystal growth.

The piezoelectric film made of a single crystal according to an embodiment can have perfectly aligned directions of polarization throughout the entire film. This will result in improved electrical and mechanical characteristics. Specifically, this will result in a higher piezoelectric constant. Moreover, a single crystal piezoelectric film can have a permittivity lower than that of polycrystalline films, which is effective in reducing power consumption and advantageous in that it can be used as a high-precision output sensor. In addition, the piezoelectric single-crystal film can have improved temperature characteristics and improved reliability due to stronger bonding forces between the atoms.

Whether or not the piezoelectric film is monocrystalline (single-crystalline) can be confirmed using X-ray diffraction in-plane Φ scan. Specifically, the piezoelectric film may be determined to be monocrystalline (single-crystalline) when four-fold symmetry peaks are observed using the in-plane Φ scan.

The piezoelectric film according to an embodiment includes lead zirconate titanate (Pb(Zr,Ti)O₃ (PZT)), barium titanate (BaTiO₃ (BT)), or potassium sodium niobate ((K,Na)NbO₃ (KNN)). PZT, BT, and KNN are all perovskite compounds represented by the formula ABO₃. Many perovskite compounds, which have a body-centered cubic crystal structure or other crystal structures, are dielectric and piezoelectric materials having dielectric and piezoelectric properties. In particular, PZT has superior piezoelectric properties and is widely used as a sensor or actuator material. Thus, the piezoelectric film preferably is made of a single crystal of lead zirconate titanate (Pb(Zr,Ti)O₃ (PZT)).

PZT may have a Zr-rich composition. Such Zr-rich PZT has a rhombohedral crystal structure. PZT may also have a Ti-rich composition. Such Ti-rich PZT has a tetragonal crystal structure. PZT may also have an intermediate composition with rhombohedral and tetragonal crystal structures coexisting to form a morphotropic phase boundary (MPB) composition, which can provide significantly high piezoelectric properties. When the composition of PZT is represented by the formula Pb(Zr₁-ₓTiₓ)O₃ (where 0 < x < 1), x is preferably 0.2 or more and 0.8 or less, more preferably 0.3 or more and 0.7 or less, even more preferably 0.4 or more and 0.6 or less, for superior piezoelectric properties.

The piezoelectric film according to an embodiment is a (001)-oriented film or a (100)-oriented film. When epitaxially grown, the piezoelectric film with a body-centered cubic crystal structure can be easily oriented in the (001) or (100) direction. For example, when epitaxially grown, the PZT film with a tetragonal crystal structure can be easily oriented in the (001) direction. The (001)-oriented PZT film with a tetragonal crystal structure has a polarization direction parallel to the [001] direction and thus parallel to its electric field direction (which is parallel to its thickness direction), which results in improved piezoelectric properties. In other words, the PZT film with a tetragonal crystal structure can have a large piezoelectric constant when an electric field is applied along the [001] direction.

In an embodiment, whether or not the piezoelectric film is a (001)- or (100)-oriented film can be determined using X-ray diffraction θ-2θ scan of the piezoelectric film. Specifically, using θ-2θ scan, the piezoelectric film may be determined to be a (001)- or (100)-oriented film when the ratio of the intensity of diffraction peaks from planes other than the (001) and (100) planes to the intensity of the diffraction peak from the desired plane ((001) plane or (100) plane) is 10% or less. The peak intensity ratio is more preferably as small as possible, such as 5% or less.

The piezoelectric film preferably has a thickness of 0.1 µm or more and 10 µm or less. With too small a thickness, the piezoelectric film may fail to be sufficiently effective or may provide a reduced magnitude of displacement. On the other hand, with too large a thickness, the piezoelectric film may hardly be sufficiently monocrystalline. The piezoelectric film more preferably has a thickness of 0.3 µm or more and 6 µm or less, even more preferably 0.5 µm or more and 4 µm or less.

### Second Metal Oxide Film

The thin-film piezoelectric device according to an embodiment may have a second metal oxide film between the piezoelectric film and the second electrode layer. The second metal oxide film includes strontium ruthenate (SrRuO₃ (SRO)). SRO is electrically conductive. Therefore, the SRO film (second metal oxide film) may be used as part of the electrode layer (second electrode layer).

The second metal oxide film (SRO film) preferably has a thickness of 1 nm or more and 60 nm or less, more preferably 3 nm or more and 30 nm or less, even more preferably 5 nm or more and 20 nm or less. The second metal oxide film is preferably an epitaxial film, more preferably a (100)-oriented epitaxial film, grown on the piezoelectric film.

### Second Electrode Layer

The first and second electrode layers form a pair of electrodes between which the piezoelectric film is sandwiched. The second electrode layer may be made of any electrically-conductive material. For example, the second electrode layer may include at least one selected from the group consisting of platinum (Pt), molybdenum (Mo), ruthenium (Ru), aluminum (Al), and copper (Cu).

The second electrode layer preferably has a thickness of 1 nm or more and 200 nm or less, more preferably 3 nm or more and 150 nm or less, even more preferably 10 nm or more and 120 nm or less. The second electrode layer is preferably an epitaxial film, more preferably a (100)-oriented epitaxial film, grown on the piezoelectric film.

### Extraction Electrode

The thin-film piezoelectric device may further include an extraction electrode provided on the second electrode layer. The extraction electrode may include a known electrically-conductive material. For example, the extraction electrode may include a stack of gold (Au) and titanium (Ti) layers. In such a stack, the Au layer mainly serves as an electrically-conductive layer while the Ti layer mainly serves as a bonding layer.

### Protective Film

The thin-film piezoelectric device may include a protective film provided on the second electrode layer or the second metal oxide film (SRO film). As a non-limiting example, the protective film may include tetraethyl orthosilicate (TEOS) or any other suitable material.

### Moving Part

The moving part is supported by (on) the substrate and includes at least the buffer film, the first electrode layer, the piezoelectric film, and the second electrode layer. The moving part may further include a metal oxide film (first metal oxide film) between the first electrode layer and the piezoelectric film and/or another metal oxide film (second metal oxide film) on the second electrode layer.

In the thin-film piezoelectric device according to an embodiment, the piezoelectric film in the moving part expands and contracts in an in-plane direction in relation to a d₃₁ mode based on a piezoelectric effect, thereby causing the moving part to be displaced. Piezoelectric effects include the longitudinal piezoelectric effect (d₃₃ mode), with the direction of the electric power input/output being the same as that of the mechanical input/output, the transverse piezoelectric effect (d₃₁ mode), with the direction of the electric power input/output being perpendicular to that of the mechanical input/output, and the piezoelectric shear effect (d₁₅ mode) (shear deformation). Thin-film piezoelectric devices configured in d₃₁ mode are advantageous in terms of fabrication process and can exhibit a large displacement.

The thin-film piezoelectric device according to an embodiment has the piezoelectric film sandwiched between the top and bottom electrodes (first and second electrode layers). When a potential difference is applied across the electrode layers (first and second electrode layers), an electric field is generated in the vertical direction of the piezoelectric film to produce an inverse piezoelectric effect (d₃₁ mode), so that displacement occurs in directions perpendicular to the electric field, namely parallel to the film plane. Alternatively, stress in a direction parallel to the film plane may be applied to the moving part to produce a positive piezoelectric effect, which generates surface charges on the electrode layer. In the d₃₁ mode, the piezoelectric film exhibits displacement in the film plane direction, which causes the moving part to be displaced. The moving part includes a stack of the piezoelectric film and other components (including the buffer film). While the piezoelectric film expands or contracts (deforms) in the in-plane direction, the other components neither expand nor contract. Thus, the moving part is deflected in response to the displacement of the piezoelectric film. The larger the displacement of the piezoelectric film, the more the deflection of the moving part.

In the thin-film piezoelectric device according to an embodiment, an angle θ between a <100> direction of the piezoelectric film and an in-plane direction which maximizes the displacement of the moving part is within ±11.5°. In this regard, the in-plane direction which maximizes the displacement of the moving part corresponds to the direction in which the magnitude of in-plane expansion or contraction of the piezoelectric film (in the direction parallel to the film plane) (deflection amount) is maximum. The term "<100> direction" is intended to include all directions equivalent to the [100] direction. The angle θ is preferably within ±11.0°, more preferably within ±10.5°.

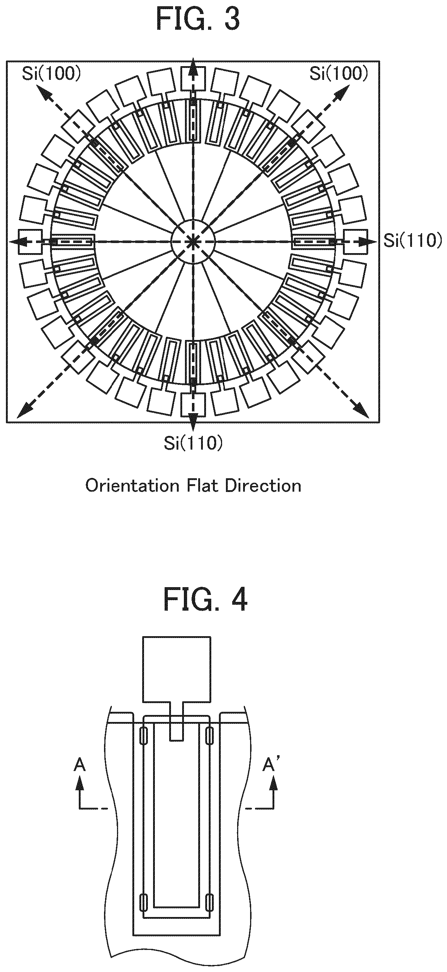

The piezoelectric film according to an embodiment has a single crystal structure. Thus, the magnitude of the piezoelectric displacement is highly dependent on the crystal plane orientation. As a result of investigation, the present inventors have found that the smaller the angle θ, namely the further the in-plane direction which maximizes the displacement of the moving part is aligned with the <100> direction of the piezoelectric film, the larger the magnitude of displacement of the piezoelectric film will be. For example, when made of single crystal PZT, the piezoelectric film can have a high d₃₁ piezoelectric constant of about 100 pm/V or more. In contrast, conventional piezoelectric films are not monocrystalline. Such piezoelectric films do not exhibit crystal plane orientation-dependent piezoelectric properties and provide a small piezoelectric displacement. For example, Non-Patent Document 1 discloses PZT thin films with a radial piezoelectric constant (d₃₁) of 25 to 60 pC/N (25 to 60 pm/V) (see Fig. 4 on page 136 of Non-Patent Document 1). Furthermore, in the conventional art, no crystal plane orientation dependency has been demonstrated, and thus no attention has been paid to the relationship between crystal plane orientation and piezoelectric performance. In an embodiment, the piezoelectric properties of the single-crystalline piezoelectric film are highly dependent on crystal plane orientation and thus characterized by being able to be significantly improved by control of crystal plane orientation.

As shown in FIGS. 1 and 2, the thin-film piezoelectric device preferably has a hollow portion (22) provided immediately below the moving part (4). In other words, at least part of the substrate (2) is removed below the moving part (4) so that the moving part (4) has a diaphragm structure. In this case, the moving part can be deflected by a large amount due to reduced constraint of the substrate to the moving part.

In the thin-film piezoelectric device according to an embodiment, the moving part preferably has an external shape with two sides parallel to each other in top view, and the in-plane direction which maximizes the displacement of the moving part is preferably consistent with a direction perpendicular to the two sides. The external shape of the moving part is preferably rectangular, substantially rectangular, or trapezoidal. The moving part having such an external shape with two sides parallel to each other can maximally expand or contract in a direction perpendicular to the two sides. The moving part with a rectangular external shape preferably has a transverse dimension (short side) of 30 µm or more and 500 µm or less, more preferably 50 µm or more and 300 µm or less. The moving part with a rectangular external shape preferably has a longitudinal dimension (long side) of 100 µm or more and 1,000 µm or less, more preferably 250 µm or more and 600 µm or less. In addition, the in-plane direction which maximizes the displacement of the moving part is preferably consistent with a direction perpendicular to the transverse direction.

In the thin-film piezoelectric device according to an embodiment, the buffer film and the first electrode layer preferably are made of a single crystal. Moreover, the buffer film, the first electrode layer, and the piezoelectric film preferably have the same crystal orientation. The piezoelectric film grown on the first electrode layer can have better crystallinity when the first electrode layer and the buffer film are single-crystalline and have the same crystal orientation.

The thin-film piezoelectric device according to an embodiment preferably has a double-supported beam structure or a single-supported beam structure and preferably has the moving part in the beam of the double- or single-supported beam structure. In the device with a single-supported beam structure, the moving part has only one end fixed and the other end free. In such a device, the free end of the moving part moves in the vertical direction in accordance with the deflection of the moving part. The single-supported beam structure is also called the cantilever structure. In contrast, in the device with a double-supported beam structure, the moving part has both ends fixed. In such a device, the center of the moving part moves in the vertical direction in accordance with the deflection of the moving part. The double-supported beam structure may also be called the diaphragm structure.

The thin-film piezoelectric device according to an embodiment is preferably for use as a sensor or an actuator. The thin-film piezoelectric device according to an embodiment features a large magnitude of displacement of the moving part. Therefore, the thin-film piezoelectric device according to an embodiment can form a sensor or actuator with superior characteristics. Examples of the sensor include acceleration sensors, gyro sensors, pressure sensors, ultrasonic sensors, flow sensors, vibration power generation devices, odor sensors, and/or microphones. Examples of the actuator include speakers, inkjet printer heads, autofocus mechanisms, mirrors, optical switches, and/or micropumps. Besides the above, the thin-film piezoelectric device according to an embodiment is suitable for use as a high-frequency circuit part, such as an RF filter or a piezoelectric thin-film resonator (film bulk acoustic resonator (FBAR)).

### 2. Method for Manufacturing the Thin-Film Piezoelectric Device

The thin-film piezoelectric device according to an embodiment may be manufactured using any method that can satisfy the requirements described above. However, a suitable method for manufacturing the thin-film piezoelectric device according an embodiment may include the steps of: providing a substrate (substrate provision step); forming, on the substrate, a buffer film including zirconium oxide (ZrO₂) (buffer film formation step); forming a first electrode layer on the buffer film (first electrode layer formation step); forming a piezoelectric film on the first electrode layer (piezoelectric film formation step); and forming a second electrode layer on the piezoelectric film (second electrode layer formation step). Such a method may further include the step of forming a first metal oxide film on the first electrode layer before the formation of the piezoelectric film (first metal oxide film formation step). Such a method may further include the step of forming a second metal oxide film on the piezoelectric film before the formation of the second electrode layer (second metal oxide film formation step). Such a method may further include the step of forming an extraction electrode on the second electrode layer and the second metal oxide film (extraction electrode formation step). Such a method may further include the step of forming a protective film on the second electrode layer, the second metal oxide film, and/or the extraction electrode (protective film formation step). Such a method may further include the step of removing at least part of the substrate below a moving part to form a hollow portion immediately below the moving part (hollow portion formation step). Each of the steps will be described in detail below.

### Substrate Provision Step

The substrate provision step includes providing a substrate. The details of the substrate are as described above. Specifically, the substrate may be a silicon (Si) substrate, a silicon-on-insulator (SOI) substrate, a substrate made of a semiconductor crystal other than Si, a substrate made of a single crystal of any of various oxides such as sapphire and garnet, or a glass substrate with a surface polysilicon film. The substrate may be of any size, such as a 4-inch substrate, a 6-inch substrate, or an 8-inch substrate. The substrate may have any suitable orientation. For example, the substrate may be a Si (100) substrate, a Si (110) substrate, or a Si (111) substrate.

### Buffer Film Formation Step

The buffer film formation step includes forming, on the substrate, a buffer film including zirconium oxide (ZrO₂). The film may be formed using electron beam evaporation, sputtering, or any other technique. An electron beam evaporation method may include placing the substrate, for example, in the vacuum chamber of an electron beam evaporation system. Such a method may include forming a zirconium oxide (ZrO₂) film on the substrate being heated under a high-vacuum atmosphere with an oxygen (O₂) gas stream at a constant pressure in the vacuum chamber. The film formation process under such conditions reliably provides a (100)-oriented epitaxial buffer film. The step may also include patterning the resulting buffer film using a photolithography technique to remove part of the buffer film.

### First Electrode Layer Formation Step

The first electrode layer formation step includes forming a first electrode layer on the buffer film. The first electrode layer includes, for example, at least one selected from the group consisting of platinum (Pt), molybdenum (Mo), ruthenium (Ru), aluminum (Al), and copper (Cu). The first electrode layer may be formed using sputtering or any other technique. A sputtering method may include, for example, epitaxially growing the first electrode layer as part of the bottom electrode by sputtering on the buffer film while heating the substrate. The step may also include patterning the resulting first electrode layer using a photolithography technique to remove part of the first electrode layer.

### First Metal Oxide Film Formation Step

A first metal oxide film (SRO film) may be formed on the first electrode layer before the formation of a piezoelectric film. The first metal oxide film may be formed using sputtering or any other technique. A sputtering method may include, for example, epitaxially growing the first metal oxide film as part of the bottom electrode by sputtering on the first electrode layer while heating the substrate. The step may also include patterning the resulting first metal oxide film using a photolithography technique to remove part of the first metal oxide film.

### Piezoelectric Film Formation Step

The piezoelectric film formation step includes forming a piezoelectric film on the first electrode layer. The piezoelectric film is a (001)- or (100)-oriented single crystal film of PZT, BT, or KNN. The piezoelectric film may be formed using sputtering, sol-gel method, or any other method. For example, the step may include epitaxially growing, on the first electrode layer, a piezoelectric film including lead zirconate titanate (Pb(Zr₁₋ₓTiₓ)O₃ (0<x<1) (PZT)) by a known sputtering method. Alternatively, the step may include epitaxially growing, on the first electrode layer, a piezoelectric film including lead zirconate titanate (Pb(Zr₁-ₓTiₓ) O₃ (0<x<1) (PZT)) by a known sol-gel method. The piezoelectric film may be formed using any suitable method that can form a (001)- or (100)-oriented single crystal film. The step may also include patterning the resulting piezoelectric film using a photolithography technique to remove part of the piezoelectric film.

### Second Metal Oxide Film Formation Step

A second metal oxide film (SRO film) may be formed on the piezoelectric film before the formation of a second electrode layer. The second metal oxide film may be formed using sputtering or any other technique. A sputtering method may include, for example, epitaxially growing the second metal oxide film as part of the top electrode by sputtering on the piezoelectric film. The step may also include patterning the resulting second metal oxide film using a photolithography technique to remove part of the second metal oxide film.

### Second Electrode Layer Formation Step

The second electrode layer formation step includes forming a second electrode layer on the piezoelectric film or the second metal oxide film. The second electrode layer includes, for example, at least one selected from the group consisting of platinum (Pt), molybdenum (Mo), ruthenium (Ru), aluminum (Al), and copper (Cu). The second electrode layer may be formed using sputtering or any other technique. A sputtering method may include, for example, epitaxially growing the second electrode layer including Pt as part of the top electrode by sputtering on the piezoelectric film or the second metal oxide film. The step may also include patterning the resulting second electrode layer using a photolithography technique to remove part of the second electrode layer.

### Extraction Electrode Formation Step

An extraction electrode may be formed on the second electrode layer. The extraction electrode may be formed using sputtering or any other technique. The step may also include patterning the resulting extraction electrode layer using a photolithography technique to remove part of the extraction electrode layer.

### Protective Film Formation Step

A protective film may be formed on the second electrode layer or the extraction electrode. As a non-limiting example, the protective film may include tetraethyl orthosilicate (TEOS) or any other suitable material. The protective film may be formed using sputtering or any other technique. The step may also include patterning the protective film using a photolithography technique to remove part of the protective film.

### Hollow Portion Formation Step

A method for manufacturing the thin-film piezoelectric device may further include the step of removing part of the substrate below a moving part to form a hollow portion immediately below the moving part. The step forms a moving part that has a cantilever structure or a diaphragm structure and can exhibit a large displacement. The hollow portion is preferably formed after the formation of the buffer film, the first electrode layer, the piezoelectric film, and the second electrode layer on the substrate.

The hollow portion may be formed by a combination of photolithography and etching techniques. Specifically, a mask with an aperture is attached to the bottom surface of the substrate. The substrate is then etched through the aperture of the mask using an alkaline etching solution. For example, the alkaline etching solution etches the Si or SOI substrate anisotropically so that a truncated pyramid-shaped hollow portion is formed. When the Si substrate is etched, the buffer film (ZrO₂ film) on the Si substrate functions as an etching stop layer. The resulting thin-film piezoelectric device has no part of the substrate immediately below the moving part. When the SOI substrate is etched, the insulating film (SiO₂ film) of the SOI substrate functions as an etching stop layer. Part of the insulating film may be removed using a hydrofluoric acid solution or any other etching solution. The resulting thin-film piezoelectric device has the surface Si layer immediately below the moving part or has the surface Si layer and the insulating film (SiO₂ film) immediately below the moving part.

### EXAMPLES

The present invention will be described in more detail with reference to the examples below. It should be noted that the examples below are not intended to limit the present invention.

### (1) Fabrication of Thin-Film Piezoelectric Devices

### Example 1

In Example 1, a buffer film (ZrO₂ film), a first electrode layer (Pt film), a first metal oxide film (SRO film), a piezoelectric film (PZT film), a second metal oxide film (SRO film), a second electrode layer (Pt film), and an extraction electrode (a Ti layer and an Au layer) were formed in this order on top of an SOI substrate, and then the bottom surface of the SOI substrate was etched such that a cavity (hollow portion) was formed. This process provided a thin-film piezoelectric device having a moving part as shown in FIG. 2.

First, a 6-inch diameter SOI wafer was provided as a substrate. The SOI substrate had a three-layer structure including a Si substrate portion, an insulating film (SiO₂ film), and a surface Si layer. The SOI substrate had a top main surface with a (100) plane. In other words, the surface Si layer was (100)-oriented.

Next, a zirconium oxide (ZrO₂) film was formed as a buffer film on the surface Si layer of the SOI substrate using an electron beam evaporation method. The resulting buffer film had a (100)-oriented cubic crystal structure and a thickness of 60 nm. The film formation conditions were as follows.
System: Electron beam evaporation system
Pressure: 7.00 × 10⁻³ Pa
Deposition source: ZrO₂
Acceleration voltage/emission current: 7.5 kV/1.80 mA
Thickness: 60 nm
Deposition rate: 0.005 nm/sec
Oxygen flow rate: 10 sccm
Substrate temperature: 500 to 600°C

Next, a Pt film was formed as a first electrode layer on the buffer film (ZrO₂ film) by sputtering. The resulting Pt film (first electrode layer) had a (100)-oriented cubic crystal structure and a thickness of 150 nm. The film formation conditions were as follows.
System: DC sputtering system
Pressure: 3.20 × 10⁻² Pa
Deposition source: Pt
Power: 100 W
Thickness: 150 nm
Deposition rate: 0.14 nm/sec
Ar flow rate: 16 sccm
Substrate temperature: 400°C

Next, an SRO film was formed as a first metal oxide film on the first electrode layer (Pt film) by sputtering. The resulting first metal oxide film had a (100)-oriented cubic crystal structure and a thickness of 40 nm. The film formation conditions were as follows.
System: RF magnetron sputtering system
Power: 300 W
Gas: Ar
Pressure: 1.8 Pa
Substrate temperature: 600°C
Deposition rate: 0.11 nm/sec
Thickness: 40 nm

A PZT film was formed as a piezoelectric film on the resulting first metal oxide film. The film formation was carried out using a sol-gel method. Specifically, first, organometallic Pb, Zr, and Ti compounds were dissolved in a mixed solvent of ethanol and 2-n-butoxyethanol to form a raw material solution. The organometallic Pb, Zr, and Ti compounds were mixed in a proportion (molar ratio) of Pb:Zr:Ti of 100+δ:52:48. The raw material solution was prepared so as to contain 0.35 mol/L of Pb(Zr_{0.52}Ti_{0.48})O₃. In the composition, δ represents the amount of excess Pb, which was set considering that some of the Pb oxide would be evaporated in the later heat treatment process. In this example, δ was set to 20. Subsequently, 20 g of poly-pyrrolidone with a K value of 27 to 33 was dissolved in the raw material solution.

Next, 3 ml of the prepared raw material solution was dropped onto the first metal oxide film (SRO film) on the substrate and then applied over the substrate by spinning the substrate at 3,000 rpm for 10 seconds. As a result, a precursor-containing coating was formed on the first metal oxide film. The substrate with the precursor-containing coating was then heated on a hot plate at 200°C for 30 seconds and further heated on the hot plate at 450°C for 30 seconds so that the coating was dried. The coating was then subjected to heat treatment at 600 to 700°C for 60 seconds in a 0.2 MPa oxygen (O₂) atmosphere so that the precursor was oxidized and crystallized. The process from the application of the raw material solution to the crystallization was repeated desired times until a piezoelectric film (PZT film) with a desired thickness was obtained.

The resulting piezoelectric film (PZT film) was (001)-oriented and 2 µm in thickness. The composition of the piezoelectric film was Pb(Zr_{0.52}Ti_{0.48})O₃.

An SRO film was formed as a second metal oxide film on the resulting piezoelectric film, and a Pt film was then formed as a second electrode layer on the SRO film. The SRO film and the Pt film were formed using sputtering. The resulting SRO film (second metal oxide film) and the resulting Pt film (second electrode layer) were 10 nm and 100 nm in thickness, respectively.

Next, the second electrode layer (Pt film), the second metal oxide film (SRO film), and the piezoelectric film (PZT film) were partially etched using a photolithography technique. Next, a tetraethoxysilane (TEOS) film was formed as a protective film on the second electrode layer using plasma CVD and then partially etched using a photolithography technique.

In addition, a 10 nm-thick Ti layer and a 300 nm-thick Au layer were formed using DC sputtering and then partially etched and removed using a photolithography technique to form an extraction electrode, which ensured the electrical connection to the second electrode layer (Pt film) (top electrode) and the second metal oxide film (SRO film).

Finally, anisotropic etching was performed on the bottom surface of the substrate (SOI substrate) to form a cavity (hollow portion). Specifically, the Si substrate portion and the insulating film (SiO₂ film) were partially removed by the etching on the bottom surface of the substrate, so that an opening was formed into the bottom side of the substrate. The process formed a moving part having a rectangular cavity (hollow portion). The moving part had planar dimensions of 70 µm (width) × 275 µm (length).

In Example 1, the thin-film piezoelectric device was designed to have a specific angle θ between the transverse direction (short side direction) of the moving part and the <100> direction of the piezoelectric film and fabricated as described above. Specifically, the moving part was so designed that the angle θ was 0°, 22.5°, 45.0°, 67.5°, 90.0°, 112.5°, 135.0°, 157.5°, or 180.0°, and with each angle θ, the corresponding thin-film piezoelectric device was fabricated.

FIGS. 3 and 4 are top views (photographs) of the resulting thin-film piezoelectric devices. FIG. 3 shows all the devices fabricated for the respective angles θ, and FIG. 4 shows one of the devices. FIG. 4 shows the moving part (see the center of FIG. 4) in which the line A-A' crossing the moving part corresponds to the transverse direction (short side direction) of the moving part.

### Example 2

Thin-film piezoelectric device samples were fabricated as in Example 1 except that the piezoelectric film (PZT film) was formed using sputtering. The piezoelectric film was formed under the following conditions.
System: RF magnetron sputtering system
Power: 2,000 W
Gas: Ar + O₂
Pressure: 1.8 Pa
Substrate temperature: 600°C
Deposition rate: 0.3 nm/sec
Thickness: 2 µm

### Example 3

Thin-film piezoelectric device samples were fabricated as in Example 1 except that a Si (100) substrate was used instead of the SOI substrate and that the buffer film (ZrO₂ film) had a thickness of 1.0 µm. The resulting thin-film piezoelectric device had a moving part as shown in FIG. 1.

### Example 4

Thin-film piezoelectric device samples were fabricated as in Example 3 except that the thickness of the buffer film (ZrO₂ film) was changed to 0.8 µm.

### Example 5

Thin-film piezoelectric device samples were fabricated as in Example 3 except that the thickness of the buffer film (ZrO₂ film) was changed to 1.2 µm.

### Example 6

Thin-film piezoelectric devices were fabricated as in Example 1 except that the cavity was so formed that the moving part had planar dimensions of 200 µm × 500 µm (different from those in Example 1) and that the moving part was designed to have an angle θ of 0°, 11.25°, 22.5°, 33.75°, 45°, 56.25°, 67.5°, 78.75°, or 90° between the transverse direction of the moving part and the <100> direction of the piezoelectric film, and with each angle θ, the corresponding thin-film piezoelectric device was fabricated.

### Example 7

Thin-film piezoelectric device samples were fabricated as in Example 6 except that the piezoelectric film (PZT film) was formed using sputtering specifically under the same conditions as those in Example 2.

### Example 8

Thin-film piezoelectric device samples were fabricated as in Example 6 except that a Si (100) substrate was used instead of the SOI substrate and that the thickness of the buffer film (ZrO₂ film) was changed to 1.0 µm.

### Example 9

Thin-film piezoelectric device samples were fabricated as in Example 8 except that the thickness of the buffer film (ZrO₂ film) was changed to 0.8 µm.

### Example 10

Thin-film piezoelectric device samples were fabricated as in Example 8 except that the thickness of the buffer film (ZrO₂ film) was changed to 1.2 µm.

The structures of the thin-film piezoelectric devices of Examples 1 to 10 are summarized in Tables 1-1 and 1-2 below.

**[Table 1-1]**

| Table 1-1: Thin-film piezoelectric device structure | | | | | |
|---|---|---|---|---|---|
| | Example 1 | Example 2 | Example 3 | Example 4 | Example 5 |
| Protective film | TEOS | TEOS | TEOS | TEOS | TEOS |
| Extraction electrode | Ti layer (10nm) + Au layer (300nm) | Ti layer (10nm) + Au layer (300nm) | Ti layer (10nm) + Au layer (300nm) | Ti layer (10nm) + Au layer (300nm) | Ti layer (10nm) + Au layer (300nm) |
| Second electrode layer | Pt film (100 nm thick) | Pt film (100 nm thick) | Pt film (100 nm thick) | Pt film (100 nm thick) | Pt film (100 nm thick) |
| Metal oxide film | SRO film (10nm thick) | SRO film (10nm thick) | SRO film (10nm thick) | SRO film (10nm thick) | SRO film (10nm thick) |
| Single-crystalline piezoelectric film | PZT film (2µm thick) | PZT film (2µm thick) | PZT film (2µm thick) | PZT film (2µm thick) | PZT film (2µm thick) |
| Metal oxide film | SRO film (40nm thick) | SRO film (40nm thick) | SRO film (40nm thick) | SRO film (40nm thick) | SRO film (40nm thick) |
| First electrode layer | Pt film (150nm thick) | Pt film (150nm thick) | Pt film (150nm thick) | Pt film (150nm thick) | Pt film (150nm thick) |
| Buffer film | ZrO₂ film (60nm thick) | ZrO₂ film (60nm thick) | ZrO₂ film (1.0µm thick) | ZrO₂ film (0.8µm thick) | ZrO₂ film (1.2m thick) |
| Substrate | SOI(100) Substrate | SOI (100) Substrate | Si(100) Substrate | Si(100) Substrate | Si (100) Substrate |
| Moving part (Cavity) Planar dimensions | 70µm ×275µm | 70µm ×275µm | 70µm ×275µm | 70µm ×275µm | 70µm ×275µm |

**[Table 1-2]**

| Table 1-2: Thin-film piezoelectric device structure | | | | | |
|---|---|---|---|---|---|
| | Example 6 | Example 7 | Example 8 | Example 9 | Example 10 |
| Protective film | TEOS | TEOS | TEOS | TEOS | TEOS |
| Extraction electrode | Ti layer (10nm) + Au layer (300nm) | Ti layer (10nm) + Au layer (300nm) | Ti layer (10nm) + Au layer (300nm) | Ti layer (10nm) + Au layer (300nm) | Ti layer (10nm) + Au layer (300nm) |
| Second electrode layer | Pt film (100 nm thick) | Pt film (100 nm thick) | Pt film (100 nm thick) | Pt film (100 nm thick) | Pt film (100 nm thick) |
| Metal oxide film | SRO film (10nm thick) | SRO film (10nm thick) | SRO film (10nm thick) | SRO film (10nm thick) | SRO film (10nm thick) |
| Single-crystalline piezoelectric film | PZT film (2µm thick) | PZT film (2µm thick) | PZT film (2µm thick) | PZT film (2µm thick) | PZT film (2µm thick) |
| Metal oxide film | SRO film (40nm thick) | SRO film (40nm thick) | SRO film (40nm thick) | SRO film (40nm thick) | SRO film (40nm thick) |
| First electrode layer | Pt film (150nm thick) | Pt film (150nm thick) | Pt film (150nm thick) | Pt film (150nm thick) | Pt film (150nm thick) |
| Buffer film | ZrO₂ film (60nm thick) | ZrO₂ film (60nm thick) | ZrO₂ film (1.0µm thick) | ZrO₂ film (0.8µm thick) | ZrO₂ film (1.2µm thick) |
| Substrate | SOI(100) Substrate | SOI (100) Substrate | Si(100) Substrate | Si(100) Substrate | Si (100) Substrate |
| Moving part (Cavity) Planar dimensions | 200µm ×500µm | 200µm ×500µm | 200µm ×500µm | 200µm ×500µm | 200µm ×500µm |

### (2) Evaluation of Thin-Film Piezoelectric Devices

The thin-film piezoelectric devices fabricated in Examples 1 to 10 were evaluated for various characteristics as follows.

### Crystallinity

The crystallinity of the piezoelectric film (PZT film) was evaluated. Specifically, before the formation of the second metal oxide film, the half-finished devices were taken out and subjected to the evaluation of the piezoelectric film using an automated multipurpose horizontal X-ray diffractometer (SmartLab, Rigaku). Specifically, 360° Φ scan measurement was performed for the 2θ-θ diffraction peak of PZT (004).

### Resonance Frequency

The resonance frequency of the thin-film piezoelectric device was measured using a spectrum impedance analyzer (4395A, Agilent Technologies, Inc.). Specifically, the probe connected to the spectrum impedance analyzer was brought into electrical contact with the top electrode (second electrode layer) and the bottom electrode (first electrode layer) of the thin-film piezoelectric device. Subsequently, while a voltage of 15 V was applied, the frequency at which impedance (Z) and phase (θ) changed was measured.

### Magnitude of Displacement

The thin-film piezoelectric device was evaluated for the magnitude of displacement of the moving part. Specifically, the probe connected to an oscilloscope (TDS3014C, Tektronix, Inc.) was brought into electrical contact with the top electrode (second electrode layer) and the bottom electrode (first electrode layer) of the thin-film piezoelectric device. Next, the measurement signal was applied across the top and bottom electrodes using Multifunction Generator WF1973 (NF Corporation). The measurement signal was applied under the conditions of Sin wave (sine wave), 1 kHz, Vpp 20V, and offset 10 V. The magnitude of displacement of the moving part in the thin-film piezoelectric device was measured using a laser Doppler vibrometer (VFX-Compact, Polytec GmbH.), and the resulting output values were input into an oscilloscope.

### (3) Evaluation Results

### Crystallinity of Piezoelectric Film

As a result of the X-ray diffraction θ-2θ scan, the piezoelectric films (PZT films) in the thin-film piezoelectric devices of Examples 1 to 10 had a ratio of the diffraction peak intensity of planes other than the (100) plane to that of the (100) plane of 0.09%. This showed that the piezoelectric films were (100)-oriented.

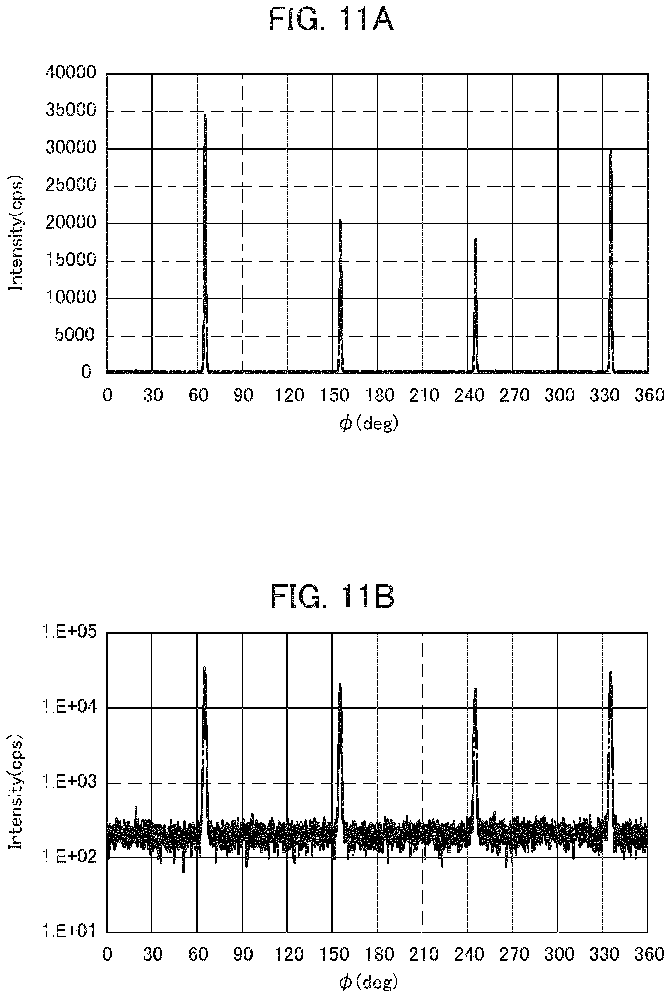

Four-fold symmetry peaks were also observed in the in-plane Φ scan. Thus, the piezoelectric films were confirmed to be three-axis-oriented single crystal films. In this regard, FIGS. 11A and 11B show the X-ray diffraction pattern (Φ scan) of the piezoelectric film (PZT film) in Example 1. FIG. 11A shows the X-ray diffraction intensity on the vertical axis (true number) while FIG. 11B shows it on a logarithmic scale.

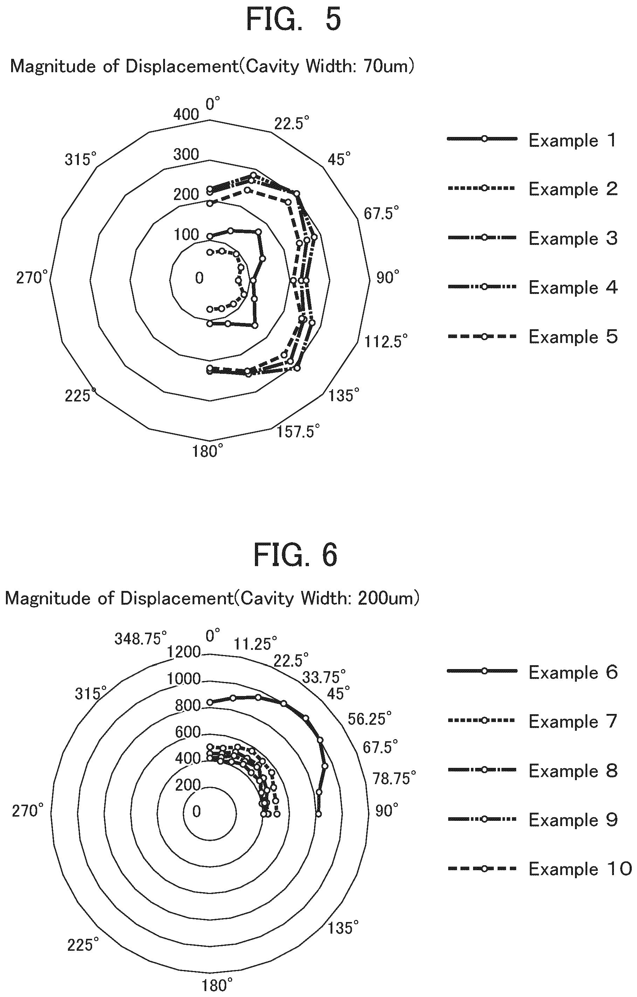

Tables 2 and 3 and FIGS. 5 and 6 show the magnitude of displacement of the moving parts in the thin-film piezoelectric devices of Examples 1 to 10. In the tables and figures, α represents the angle (unit: °) between the longitudinal direction of the moving part in the device and the direction [110] of the orientation flat of the substrate wafer. The angle θ is between the in-plane direction in which the moving part exhibits a maximum displacement and the <100> direction of the piezoelectric film. In the examples, the piezoelectric film is (100)-oriented. The crystal orientation of the piezoelectric film is also consistent with the crystal orientation of the substrate. Therefore, θ and α satisfy the relation θ = α - 45°.

Tables 2 and 3 and FIGS. 5 and 6 show that in the α range of 0 to 45°, the magnitude of displacement increases with increasing angle α and that in the α range of 45 to 90°, the magnitude of displacement decreases with increasing angle α. In other words, the magnitude of displacement is maximum at an angle α of around 45° (an angle θ of around 0°).

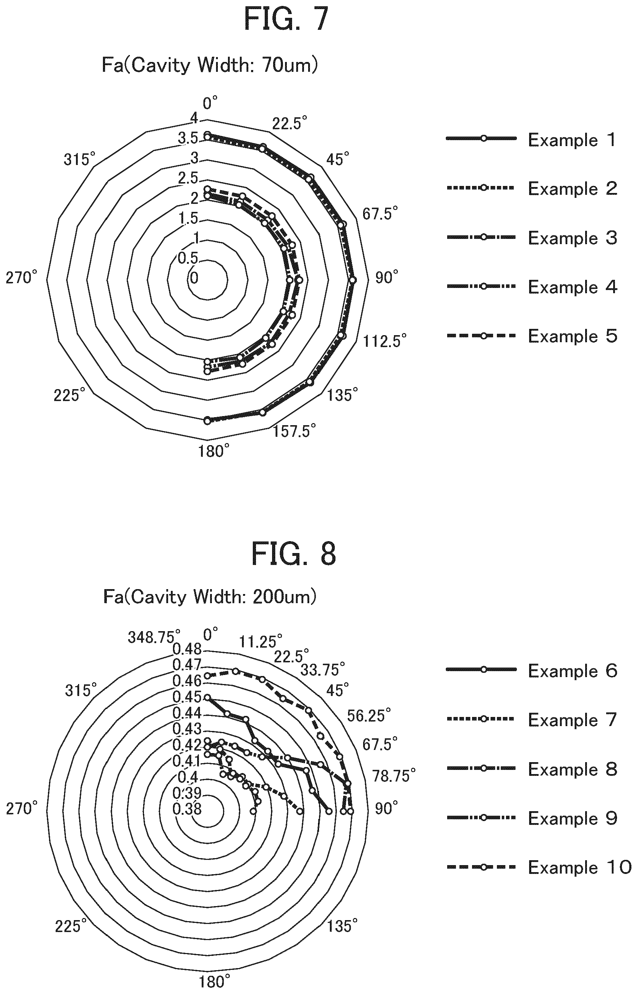

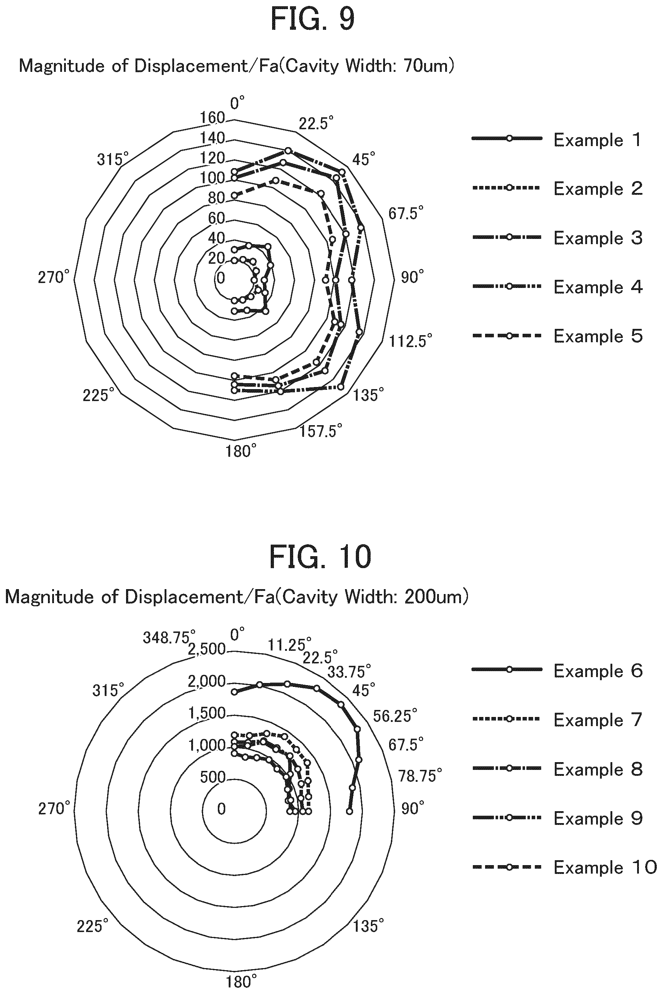

The resonance frequency Fa of the piezoelectric film is shown in Tables 4 and 5 and FIGS. 7 and 8. The displacement/resonance frequency Fa is shown in Tables 6 and 7 and FIGS. 9 and 10. The resonance frequency Fa showed a reverse tendency to the magnitude of displacement. Specifically, in the α range of 0 to 45°, Fa decreases with increasing angle α, and in the α range of 45 to 90°, Fa increases with increasing angle α. In other words, Fa is minimum at an angle α of around 45° (an angle θ of around 0°).

Those results support that thin-film piezoelectric devices with the angle θ (between the in-plane direction which maximizes the displacement of their moving part and the <100> direction of their piezoelectric film) falling within the specified range will have superior piezoelectric properties and exhibit a large displacement.

**[Table 2]**

| Table 2: Magnitude of displacement in thin-film piezoelectric dev: | | | | | |
|---|---|---|---|---|---|
| α (°) | Magnitude of displacement (nm) | | | | |
| | Example 1 | Example 2 | Example 3 | Example 4 | Example 5 |
| 0.0 | 110 | 70 | 220 | 228 | 192 |
| 22.5 | 134 | 79 | 270 | 284 | 244 |
| 45.0 | 171 | 93 | 306 | 306 | 276 |
| 67.5 | 142 | 84 | 262 | 282 | 242 |
| 90.0 | 108 | 71 | 228 | 240 | 208 |
| 112.5 | 120 | 92 | 254 | 276 | 248 |
| 135.0 | 159 | 83 | 284 | 308 | 262 |
| 157.5 | 117 | 76 | 250 | 252 | 244 |
| 180.0 | 108 | 72 | 226 | 224 | 218 |

**[Table 3]**

| Table 3: Magnitude of displacement in thin-film piezoelectric dev: | | | | | |
|---|---|---|---|---|---|
| α (°) | Magnitude of displacement (nm) | | | | |
| | Example 6 | Example 7 | Example 8 | Example 9 | Example 10 |
| 0.00 | 840 | 505 | 455 | 420 | 420 |
| 11.25 | 890 | 505 | 465 | 435 | 405 |
| 22.50 | 950 | 545 | 505 | 475 | 425 |
| 33.75 | 1000 | 570 | 505 | 475 | 450 |
| 45.00 | 1020 | 560 | 520 | 500 | 440 |
| 56.25 | 1000 | 560 | 460 | 485 | 450 |
| 67.50 | 940 | 520 | 420 | 465 | 420 |
| 78.75 | 840 | 505 | 400 | 435 | 420 |
| 90.00 | 820 | 505 | 440 | 435 | 405 |

**[Table 4]**

| Table 4: Resonance frequency Fa of thin-film piezoelectric device | | | | | |
|---|---|---|---|---|---|
| α (°) | Resonance frequency Fa (MHz) | | | | |
| | Example 1 | Example 2 | Example 3 | Example 4 | Example 5 |
| 0.00 | 3.630 | 3.570 | 2.155 | 2.105 | 2.270 |
| 22.50 | 3.600 | 3.545 | 2.125 | 2.030 | 2.265 |
| 45.00 | 3.630 | 3.555 | 2.120 | 2.010 | 2.260 |
| 67.50 | 3.645 | 3.575 | 2.170 | 2.059 | 2.280 |
| 90.00 | 3.620 | 3.600 | 2.250 | 2.045 | 2.285 |
| 112.50 | 3.640 | 3.580 | 2.200 | 2.040 | 2.280 |
| 135.00 | 3.620 | 3.585 | 2.220 | 2.045 | 2.265 |
| 157.50 | 3.585 | 3.570 | 2.190 | 2.095 | 2.265 |
| 180.00 | 3.490 | 3.525 | 2.170 | 2.035 | 2.280 |

**[Table 5]**

| Table 5: Resonance frequency Fa of thin-film piezoelectric device | | | | | |
|---|---|---|---|---|---|
| α (°) | Resonance frequency Fa (MHz) | | | | |
| | Example 6 | Example 7 | Example 8 | Example 9 | Example 10 |
| 0.00 | 0.4510 | 0.4240 | 0.4200 | 0.4155 | 0.4645 |
| 11.25 | 0.4420 | 0.4195 | 0.4240 | 0.4155 | 0.4690 |
| 22.50 | 0.4420 | 0.4150 | 0.4240 | 0.4050 | 0.4690 |
| 33.75 | 0.4330 | 0.4060 | 0.4240 | 0.4085 | 0.4645 |
| 45.00 | 0.4330 | 0.4105 | 0.4280 | 0.4085 | 0.4690 |
| 56.25 | 0.4330 | 0.4105 | 0.4400 | 0.4085 | 0.4645 |
| 67.50 | 0.4465 | 0.4195 | 0.4560 | 0.4120 | 0.4690 |
| 78.75 | 0.4465 | 0.4285 | 0.4680 | 0.4120 | 0.4690 |
| 90.00 | 0.4555 | 0.4375 | 0.4645 | 0.4085 | 0.4690 |

**[Table 6]**

| Table 6: Displacement/resonance frequency Fa of thin-film piezoelectric device | | | | | |
|---|---|---|---|---|---|
| α (°) | Displacement/resonance frequency Fa (nm/MHz) | | | | |
| | Example 1 | Example 2 | Example 3 | Example 4 | Example 5 |
| 0.00 | 30.3 | 19.6 | 102.1 | 108.3 | 84.6 |
| 22.50 | 37.2 | 22.3 | 127.1 | 139.9 | 107.7 |
| 45.00 | 47.1 | 26.2 | 144.3 | 152.2 | 122.1 |
| 67.50 | 39.0 | 23.5 | 120.7 | 137.0 | 106.1 |
| 90.00 | 29.8 | 19.7 | 101.3 | 117.4 | 91.0 |
| 112.50 | 33.0 | 25.7 | 115.5 | 135.3 | 108.8 |
| 135.00 | 43.9 | 23.2 | 127.9 | 150.6 | 115.7 |
| 157.50 | 32.6 | 21.3 | 114.2 | 120.3 | 107.7 |
| 180.00 | 30.9 | 20.4 | 104.1 | 110.1 | 95.6 |

**[Table 7]**

| Table 7: Displacement/resonance frequency Fa of thin-film piezoelectric device | | | | | |
|---|---|---|---|---|---|
| α (°) | Displacement/resonance frequency Fa (nm/MHz) | | | | |
| | Example 6 | Example 7 | Example 8 | Example 9 | Example 10 |
| 0.00 | 1862.5 | 1191.0 | 1083.3 | 1010.8 | 904.2 |
| 11.25 | 2013.6 | 1203.8 | 1096.7 | 1046.9 | 863.5 |
| 22.50 | 2149.3 | 1313.3 | 1191.0 | 1172.8 | 906.2 |
| 33.75 | 2309.5 | 1403.9 | 1191.0 | 1162.8 | 968.8 |
| 45.00 | 2355.7 | 1364.2 | 1215.0 | 1224.0 | 938.2 |
| 56.25 | 2309.5 | 1364.2 | 1045.5 | 1187.3 | 968.8 |
| 67.50 | 2105.3 | 1239.6 | 921.1 | 1128.6 | 895.5 |
| 78.75 | 1881.3 | 1178.5 | 854.7 | 1055.8 | 895.5 |
| 90.00 | 1800.2 | 1154.3 | 947.3 | 1064.9 | 863.5 |

### EXPLANATION OF REFERENCE NUMERALS

2: Substrate
2-1: Si substrate portion
2-2: Insulating film
2-3: Surface Si layer
4: Moving part
6: Buffer film
8: First electrode layer
10: First metal oxide film
12: Piezoelectric film
14: Second metal oxide film
16: Second electrode layer
18: Extraction electrode
18-1: Ti layer
18-2: Au layer
20: Protective film
22: Hollow portion

## Claims

1. A thin-film piezoelectric device comprising: a substrate; and a moving part supported by the substrate,
the moving part comprising at least: a buffer film comprising zirconium oxide (ZrO₂) provided on the substrate; a first electrode layer provided on the buffer film; a piezoelectric film provided on the first electrode layer; and a second electrode layer provided on the piezoelectric film,
the piezoelectric film being a (001)- or (100)-oriented film comprising a single crystal of lead zirconate titanate (Pb(Zr,Ti)O₃ (PZT)), barium titanate (BaTiO₃ (BT)), or potassium sodium niobate ((K,Na)NbO₃ (KNN)),
wherein the piezoelectric film in the moving part expands and contracts in an in-plane direction in relation to a d₃₁ mode based on a piezoelectric effect, thereby causing the moving part to be displaced, and
wherein an angle θ between a <100> direction of the piezoelectric film and an in-plane direction which maximizes a displacement of the moving part is within ±11.5°.

2. The thin-film piezoelectric device according to claim 1, wherein, in top view, the moving part has an external shape with two sides parallel to each other, and wherein the in-plane direction which maximizes the displacement of the moving part is consistent with a direction perpendicular to the two sides.

3. The thin-film piezoelectric device according to claim 2, wherein the external shape of the moving part is rectangular, substantially rectangular, or trapezoidal.

4. The thin-film piezoelectric device according to claim 1 or 2, wherein one or both of the first and second electrode layers comprise at least one selected from the group consisting of platinum (Pt), molybdenum (Mo), ruthenium (Ru), aluminum (Al), and copper (Cu).

5. The thin-film piezoelectric device according to claim 1 or 2, further comprising a first metal oxide film comprising strontium ruthenate (SrRuO₃ (SRO)) between the first electrode layer and the piezoelectric film.

6. The thin-film piezoelectric device according to claim 1 or 2, further comprising a second metal oxide film comprising strontium ruthenate (SrRuO₃ (SRO)) between the piezoelectric film and the second electrode layer.

7. The thin-film piezoelectric device according to claim 1 or **2,** wherein the substrate is a Si substrate or an SOI substrate.

8. The thin-film piezoelectric device according to claim 1 or **2,** wherein the piezoelectric film comprises a single crystal of lead zirconate titanate (Pb(Zr,Ti)O₃ (PZT)).

9. The thin-film piezoelectric device according to claim 1 or **2,** wherein the buffer film and the first electrode layer each comprise a single crystal.

10. The thin-film piezoelectric device according to claim **9,** wherein the buffer film, the first electrode layer, and the piezoelectric film have a same crystal orientation.

11. The thin-film piezoelectric device according to claim 1 or **2,** wherein the thin-film piezoelectric device has a double-supported beam structure or a single-supported beam structure, and wherein the moving part forms a beam in the double- or single-supported beam structure.

12. The thin-film piezoelectric device according to claim 1 or 2, wherein the thin-film piezoelectric device is for use as a sensor or an actuator.
